# EUROPÄISCHE PATENTSCHRIFT

(11) **EP 1 876 515 B1**
(45) Veröffentlichungstag und Bekanntmachung des Hinweises auf die Patenterteilung: **09.12.2009**
(21) Anmeldenummer: 07111379.9
(22) Anmeldetag: 29.06.2007
(51) Int. Cl.: G06F 3/033, H03K 17/96, F24C 7/08, H05B 3/74

(54) **Bedienvorrichtung**
Operating device
Dispositif de commande

(30) Priorität: 03.07.2006 DE 102006030556
(43) Veröffentlichungstag der Anmeldung: 09.01.2008
(73) Patentinhaber: BSH Bosch und Siemens Hausgeräte GmbH, 81739 München (DE)
(72) Erfinder: Has, Uwe, 84579 Unterneukirchen (DE); Maier, Thomas, 84518 Garching a.d. Alz (DE); Vetterl, Peter, 83355 Grabenstätt (DE)
(74) Vertreter: Richter, Harald

(56) Entgegenhaltungen:
- EP-A- 1 273 851
- DE-U1- 29 519 714
- US-A- 5 673 041
- US-A1- 2005 275 567

## Beschreibung

Die Erfindung betrifft eine Bedienvorrichtung, insbesondere für Haushaltsgeräte, aufweisend zumindest ein berührungsempfindliches Bedienelement, das eine Bedienfläche mit zumindest einem daran angebrachten Bedienelementsensor aufweist, welcher eine Verformung der Bedienfläche am Bedienelementsensor erfasst.

Aus DE 299 12 917 U1 ist ein Standherd mit einem eine Herdplatte aus Glaskeramik aufweisenden Einbaukochfeld bekannt, mit wenigstens einer Kochzone auf der Herdplatte, mit einer Steuerung und Bedienungselementen zur Bedienung der Kochzone, wobei das Einbaukochfeld unmittelbar in den Standherd eingebaut ist. Als Bedienelemente sind beispielsweise Gleitstreifen aus DE 35 23 284 A1 oder aus DE 101 33 135 B4 bekannt.

Aus US 2005/0275567 A1 ist ein beweglicher berührungsempfindlicher Schalter, und insbesondere ein redundanter beweglicher berührungsempfindlicher Schalter bekannt, der durch eine Biegung eines piezo-elektrischen Verbundwerkstoffs und einer Potenzialänderung eines elektromagnetischen Feldes aktiviert wird.

Aus EP 1 273 851 A2 ist eine Stelleinheit für Gargeräte bekannt. Sie weist einen berührungsempfindlichen Stellstreifen auf, dessen Stellabschnitten Stellwerte oder Stellwertbereiche einer vorbestimmten Stellkurve zugeordnet oder wahlweise zuordenbar sind.

Aus US 5,673,041 ist ein berührungsempfindlicher Schalter, und insbesondere ein solcher Schalter bekannt, der gemäß einem Reflexionsbasierenden Ultraschallprinzip arbeitet.

Aus DE 295 19 714 U1 ist ein Bedienungselement für ein Haushaltsgerät bekannt, woran eine dielektrische Platte vorgesehen ist, deren eine Oberfläche nach außen frei liegt, wobei im Bereich der der einen Oberfläche abgekehrten Plattenseite eine elektrische Abgriffselektrode angeordnet ist. Die Platte ist der Abgriffelektrode gegenüberliegend, dickenreduzierend eingeformt. Zwischen der einen Plattenoberfläche und der Abgriffelektrode ist dort ein Bereich erhöhten Zugriffes und gleichzeitig eine Fingerführung für die Bedienung erstellt.

Üblicherweise werden die Bedienelemente mit einem gemeinsamen Elektronikmodul gekoppelt, das Stellwerte an eine zentrale Steuereinheit ausgibt, welche die entsprechende(n) Funktion(en) mittels der Stellwerte beginnt, steuert und / oder beendet. Damit die Stellwerte erzeugt werden können, muss die Betätigung eines entsprechenden berührungsempfindlichen Bedienelements ausreichend fest sein, damit das zugehörige Sensorelement ein Sensorsignal ausgeben kann, das sich ausreichend vom Rauschen abhebt. Bei vielen heutigen Haushaltsgeräten befindet sich dieses Sensorelement auf der Unterseite einer Bedienfläche und wird mittels eines Durchbiegens der Bedienfläche, und damit mittels einer Verformung des Sensorelements, im Bereich des Sensorelements betätigt.

Beispielsweise wird bei einem piezoelektrischen Sensorelement seine Durchbiegung als Sensorsignal eine Spannungsdifferenz erzeugen, die erfasst und in Sensorwerte umgewandelt werden kann, welche wiederum durch elektronische Schaltungen zur Gerätesteuerung verwendet werden können. Theoretisch könnten nun die Dauer und die Stärke der Betätigung über die Spannungshöhe abgeleitet werden. In der Praxis jedoch baut sich die Ladungstrennung durch Kriechströme am Sensorelement oder durch unvermeidliche parasitärer Widerstände der zugehörigen Beschaltung mit der Zeit ab; als analoges Schaltungselement kann das piezoelektrische Sensorelement in dieser Beziehung als Parallelschaltung eines Kondensators mit einem hochohmigen Widerstand aufgefasst werden. Durch diesen Ladungsausgleich bleibt die Spannungshöhe nicht mehr konstant, so dass die Betätigungsstärke und die Betätigungsdauer bei längerer oder schwacher Betätigung nicht mehr sicher abgeleitet werden können. Insbesondere ist ein Beenden der Bedienung durch Abhebens eines Fingers häufig nur schwierig zu erfassen. Daher ist es in der Praxis bisher nur sinnvoll möglich, berührungsempfindliche Sensorelemente als differenzierende Bedienelemente zur Erkennung einer vergleichsweise kurzen Betätigung zu verwenden, nicht aber als Bedienelemente mit Dauerbetätigungsfunktion, und zwar insbesondere dort nicht, wo Berührungen nur geringe Messignale erzeugen bzw. das Signal-zu-Rausch-Verhältnis hoch ist.

Es ist daher die Aufgabe der vorliegenden Erfindung, eine Möglichkeit zur sicheren Erfassung einer Betätigungsdauer eines, insbesondere berührungsempfindlichen, Bedienelements bereitzustellen.

Die Aufgabe wird gelöst durch eine Bedienvorrichtung nach Anspruch 1, ein Verfahren nach Anspruch 7 und ein Haushaltsgerät nach Anspruch 8. Vorteilhafte Ausgestaltungen ergeben sich insbesondere aus den Unteransprüchen einzeln oder in Kombination.

Die Bedienvorrichtung, insbesondere für Haushaltsgeräte, weist zumindest ein berührungsempfindliches Bedienelement auf, das eine Bedienfläche mit zumindest einem daran angebrachten Bedienelementsensor (Messaufnehmer) aufweist, welcher eine Verformung der Bedienfläche am Bedienelementsensor erfasst, bei untenliegendem Sensorelement also eine Verformung der Bedienfläche oberhalb des Sensorelements. Die Bedienvorrichtung weist ferner einen Bedienflächenberührungssensor auf, der eine Berührung der Bedienfläche im wesentlichen, also ohne signifikante Einschränkung für die Dauer eines typischen Bedienungsvorgangs, dauerunabhängig erfassen kann. Der Bedienelementsensor und der Bedienflächenberührungssensor sind mit einer gemeinsamen Auswertelogik verbunden, welche eine Betätigung des Bedienelementsensors aus einem vom Bedienelementsensor erzeugten Bedienelementsensorwert erkennt und eine Dauer einer Betätigung des Bedienelementsensors aus einem vom Bedienflächenberührungssensor erzeugten Bedienflächenberührungssensorwert erkennt. Dann kann durch die Auswertelogik aus beiden Sensorwerten auf einfache Weise ein Stellsignal für die dem Bedienelementsensor zugeordnete Gerätefunktion erzeugt werden. Eine Stellsignalinformation über die Betätigung des Bedienelementsensors kann aus dem zugehörigen Sensorwert des Bedienelementsensors abgeleitet werden, und eine Stellsignälinformation über die Betätigungsdauer des Bedienelementsensors kann aus dem Sensorwert des Bedienflächenberührungssensors abgeleitet werden. In einem Fall kann ein Stellsignal durch den Sensorwert des Bedienelementsensors auf "EIN" geschaltet werden und nach Ablauf der Betätigungsdauer auf "AUS". Alternativ kann die Auswertelogik den Stellwert bei ausreichender Betätigungsdauer inkrementieren oder dekrementieren, z. B. mit gleichbleibender Rate oder mit sich zeitlich erhöhender Rate.

Durch diese Bedienvorrichtung kann die in der Regel ausreichend starke Berührung des berührungsempfindlichen Bedienelements verwendet werden, um den Ort der Betätigung festzustellen, d. h., welches Bedienelement betätigt wurde, als auch um den Beginn der Berührung bzw. Bedienung festzustellen. Mittels des Bedienflächenberührungssensor kann dann die Dauer der Berührung erfasst werden. Dabei wird vorausgesetzt, dass das Sensorsignal des Bedienflächenberührungssensor vom gleichen Berührungsvorgang stammt, durch den das Sensorsignal des Bedienelementsensor erzeugt wurde. Somit lässt sich die Bedienungsdauer auch für Bedienelemente mit dauerabhängigem Sensorsignal zuverlässig erfassen.

Diese Berührungserfassung kann somit ortsunabhängig durchgeführt werden.

Besonders vorteilhaft ist die Verwendung mehrerer berührungsempfindlichen Bedienelement mit einer gemeinsamen Bedienfläche, z. B. einer gemeinsamen Bedienblende, z. B. einer Kochplatte, da sich so mehrere Bedienelemente einen Bedienflächenberührungssensor teilen können, was einen Aufwand reduziert.

Der Bedienflächenberührungssensor ist vorteilhafterweise ein Impedanzsensor. Die Impedanz bzw. Impedanzänderung der Bedienfläche kann bei Berührung durch einen Bediener, der immer einen gewissen Leiter darstellt, erfasst werden, z. B. normiert gegen ein festes Bezugspotential, insbesondere die Erde eines Stromnetzes.

Zur Impedanzmessung ist es sinnvoll, wenn die nutzerseitige Oberfläche der Bedienfläche leitfähig ist, was die Messempfindlichkeit erhöht. Dazu kann die Bedienfläche beispielsweise aus Metall bestehen, metallisch oberflächenbeschichtet sein oder statt Metall ein anderes leitfähiges Material an ihrer nutzerseitigen Oberfläche aufweisen, z. B. ein leitfähiges Polymer, z. B. in Form einer Aufziehfolie.

Es ist insbesondere günstig, wenn der Impedanzsensor mit einer Frequenz zwischen 15 und 100 KHz betrieben wird; allerdings ist der Impedanzsensor nicht auf diesem Bereich beschränkt, sondern kann beispielsweise auch bei 450 KHz bis 500 KHz betrieben werden.

Alternativ kann die Berührung zum Beispiel einer lichtdurchlässigen Bedienfläche durch Erfassen der Leuchtdichtenänderung bei Berührung der Oberfläche und damit durch eine Änderung des Lichtmusters bzw. der Lichtintensität an einem Abtastpunkt, z. B. durch Lichtableitung nach Außen, erfasst werden.

Es ist zur Erhöhung der Benutzerfreundlichkeit besonders günstig, wenn das berührungsempfindliche Bedienelement ein Gleitstreifen, auch Stellstreifen oder Slider genannt, ist. Dann kann die Funktion des Gleitstreifen um Dauerbetätigungen erweitert werden, was zum Beispiel für Inkrement- und Dekrement-Betätigungen sehr vorteilhaft ist.

In einer Ausgestaltung wird eine Berührung der Bedienfläche durch den Bedienelementsensor erfasst und ein zugehöriger Sensorwert an die Auswertelogik ausgegeben. Gleichzeitig oder danach wird eine Berührung der Bedienoberfläche durch den Bedienflächenberührungssensor erfasst und ein zugehöriger Sensorwert an die Auswertelogik ausgegeben. Die Auswertelogik erzeugt ein Stellsignal für die dem Bedienelementsensor zugeordnete Gerätefunktion aus den Sensorwerten, wobei eine Stellsignalinformation über die Betätigung des Bedienelementsensors aus dem zugehörigen Sensorwert des Bedienelementsensors abgeleitet wird und eine Stellsignalinformation über die Betätigungsdauer des Bedienelementsensors aus dem Sensorwert des Bedienflächenberührungssensors abgeleitet wird.

Im Folgenden wird ein Ausführungsbeispiel der Erfindung mit Hilfe einer Figur schematisch dargestellt. Dieses Ausführungsbeispiel ist als die Erfindung nicht beschränkend zu verstehen; die Figur ist nicht maßstabsgerecht.
- Figur 1: zeigt eine Draufsicht auf Elemente einer Herdoberseite;
- Figur 2: zeigt eine Schnittdarstellung in Seitenansicht eine Skizze einer Bedienvorrichtung nach dem Stand der Technik;
- Figur 3: zeigt eine Schnittdarstellung in Seitenansicht eine Skizze einer Bedienvorrichtung mit einem Bedienflächenberührungssensor.

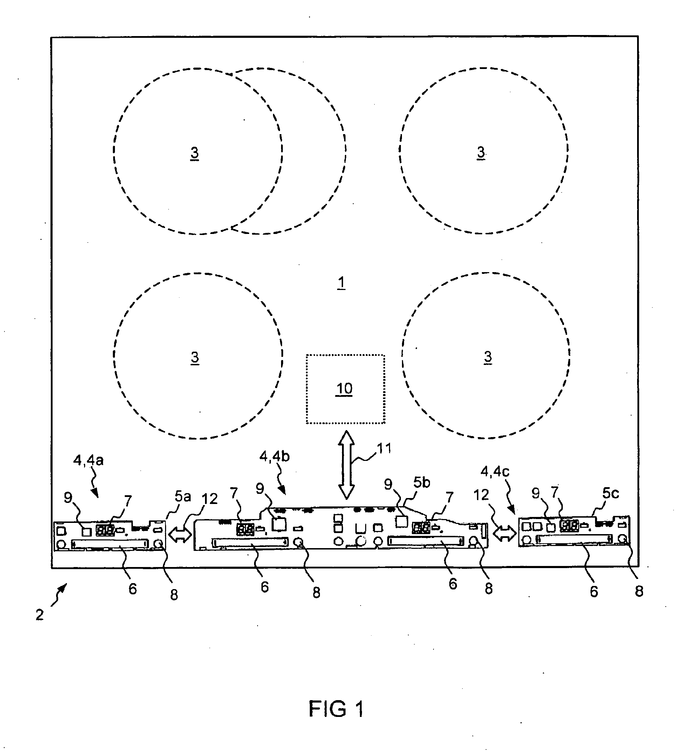

FIG 1 zeigt eine Draufsicht auf ein Kochfeld 1 eines Herds 2, mit Darstellung der Positionen einiger zugeordneter funktionaler Elemente, nämlich der Positionen von vier getrennt ansteuerbaren Kochzonen 3, die hier durch einen mittels Strahlungsheizkörpern (nicht dargestellt) beheizbaren Bereich einer Glaskeramikplatte definiert werden, sowie die Position eines Bedienfelds 4, das intern in drei Teilbedienfelder 4a, 4b, 4c unterteilt ist. Die Kochzonen 3 können zueinander unterschiedlich ausgelegt sein, z. B. funktional mit einer zusätzlichen Bräterzone (oben links dargestellte Kochzone), mit unterschiedlichen Durchmessern und / oder Heizleistungen.

Zur übersichtlichen Beschreibung des Bedienfelds 4 sind nur diejenigen Bedien- und Anzeigeelemente mit Bezugszeichen versehen, auf die im folgenden genauer eingegangen werden wird; dabei stellen runde Elemente Tasten dar, und quadratische Elemente stellen Anzeigeleuchten dar. Ausser den Tasten und Leuchten sind auch Gleitstreifen 6 (häufig "Slider" oder Stellstreifen genannt) in Form von Lineargleitstreifen und alphanumerische Anzeigen 7 in Form von 7-Segment-Anzeigen vorhanden.

Die Bedien- und Anzeigeelemente der Teilbedienfelder 4a, 4b, 4c sind auf jeweiligen Elektronikmodulen bzw. Platinen 5a, 5b, 5c aufgebracht, die geeignete elektrische Anschlüsse (nicht dargestellt) zur Stromversorgung und / oder Signal-übermittlung aufweisen. In diesem Ausführungsbeispiel ist das mittlere, größte Teilbedienfeld 4b bzw. Elektronikmodul 5b als Masterbedienfeld (Hauptbedienfeld) bzw. Masterelektronikmodul 5b ausgestaltet, und die anderen Teilbedienfelder 4a, 4c bzw. Elektronikmodule 5a, 5c als Slavebedienfelder (anhängige Bedienfelder) bzw. Slaveelektronikmodule 5a, 5c. Die Slaveelektronikmodule 5a, 5c weisen jeweils eine Auswerteelektronik (nicht dargestellt) zur Umsetzung der Messsignale der ihnen zugeordneten Gleitstreifen 6 und Tasten in Datensignale auf, da eine direkte Übertragung der relativ schwachen Messignale zum Masterelektronikmodul 5b einen Auswertefehler erhöhen würde. Genauer gesagt weisen die Elektronikmodule 5a-c in dieser Ausführungsform nur den einem berührungsempfindlichen Bedienelement, z. B. dem Gleitstreifen 6, zugeordneten Messaufnehmer auf, z. B. einen kapazitiven, resistiven oder piezoelektrischen Messaufnehmer. Durch Andrücken des Messaufnehmers wird eine mechanische Kopplung mit der Gerätefläche, hier: einer Glaskeramik-Kochfeldplatte, bewirkt. Zur Ermöglichung einer zuverlässigen Impedanzmessung ist die Glaskeramik im Bereich der Bedienelemente mit einem leitfähigen Material oberflächenbeschichtet und kann so für den Nutzer eine Bedienblende definieren. Beim Berühren der beschichteten Glaskeramikplatte oberhalb des darunter angebrachten Messaufnehmers wird diese leicht verformt, was die Messaufnehmer erfassen. Bei solchen berührungsempfindlichen Bedienelementen wird ein Bedienelement eines Bedienfelds 4 somit durch die Gerätefläche in Kombination mit dem angedrückten Elektronikmodul 5a-c definiert.

Nur das Masterelektronikmodul 5b ist direkt mit der zentralen Steuerschaltung 10 über einen ersten Datenbus 11 bzw. einen ersten Teil 11 eines gemeinsamen Datenbusses des Herds 2 verbunden. Die Teilelektronikmodule 5a, 5b, 5c sind zur Datenübertragung über einen zweiten Datenbus 12 bzw. einen zweiten Teil 12 des gemeinsamen Datenbusses verbunden. Der Datenbus 11,12 ist hier ein LIN ("Local Interconnect Network")-Feld-bus, da dieser besonders kostengünstig realisierbar ist. Das Master-Elektronikmodul 5b entspricht dann dem LIN-Master, die anderen Elektronikmodule 5a, 5c jeweils einem LIN-Slave.

Im besonderen ist das Bedienfelds 4 mit den zugehörigen Bedien- und Anzeigeelementen so ausgestaltet, dass jede Kochzone 3 durch eine jeweilige Gruppe von Bedien- und Anzeigeelementen steuerbar ist. Jede solche Gruppe umfasst hier zumindest einen Gleitstreifen 6, eine alphanumerische Anzeige 7, ein Timer-Bedienelement 8 und eine Temperaturanzeigeleuchte 9. Der Gleitstreifen 6 dient zur Einstellung von Betriebsparametern der zugeordneten Kochzone 3, wie beispielsweise einer Kochstufe oder einer Zeiteinstellung ("Timer-Einstellung"). Die alphanumerische Anzeige 7 zeigt den Wert des gerade aktiven Betriebsparameters an. Durch Betätigung des Timer-Bedienelements 8 kann eine Zeiteinstellungsbetriebsart aktiviert werden, z. B. eine Kochzeit bei angeschalteter Kochzone 3 und eine Weckerzeit bei ausgeschalteter Kochzone 3. Die Temperaturanzeigeleuchte 9 leuchtet zur Benutzerwarnung, wenn die zugeordnete Kochzone 3 eine voreingestellte Temperatur überschreitet. Somit kann eine bestimmte Kochzone 3 nur durch die ihre zugeordnete Gruppe gesteuert werden; die Steuerung der verschiedenen Kochzonen 3 kann parallel und unabhängig erfolgen.

Andere Bedien- und Anzeigeelemente können beispielsweise einen Hauptschalter, eine Verriegelungstaste zum Wischschutz, eine Bräterzonenzuschalttaste, eine Hauptmenutaste, ein Menuanzeigefeld usw. umfassen.

In dem gezeigten Ausführungsbeispiel ist die räumliche Anordnung der Gleitstreifen 6 so, dass sie entlang einer Linie am Rand des Kochfelds 2 ausgerichtet sind, nicht entsprechend der Anordnung der Kochzonen 3, was für die Kochzonen 3 Platz schafft.

Das Kochfeld 2 kann oberhalb der Bedienelemente 6, 8 bzw. der Elektronikmodule 5 in Form einer Bedienblende mit einer leitfähigen Oberfläche ausgestaltet sein, z. B. in Form einer von der die Kochzonen 3 überdeckenden Glaskeramikplatte abgesetzten metallischen oder metall-oberflächenbeschichteten Bedienblende oder in Form einer auf die Glaskeramikplatte aufgesetzten leitfähigen Polymerschicht.

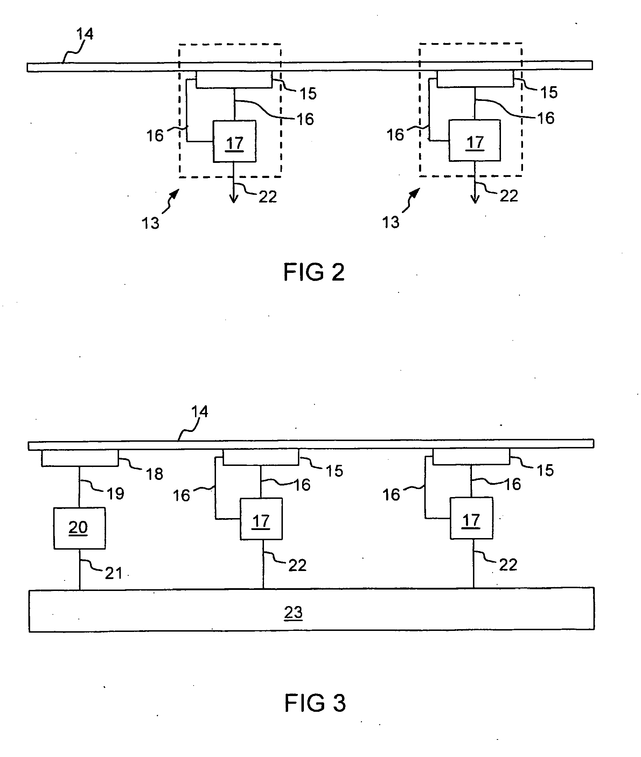

FIG 2 zeigt eine skizzenhafte Seitenansicht zweier berührungsempfindlicher Bedienelemente 13, die unterhalb einer bedienerseitig oberflächenleitfähigen Hausgerätefläche 14, z. B. einer Bedienblende aus Metall, angebracht jeweils ein Piezosensorelement 15 aufweisen. Bei Berührung der Fläche 14 oberhalb des Sensorelements 15 werden die Fläche 14 und damit das hier darunterliegende Sensorelement 15 (Messaufnehmer) leicht durchgebogen. Dieser Bereich der Fläche 14 kann somit als Teil des Bedienelements 13 angesehen werden, wie auch durch den gestrichelten Kasten schematisch angedeutet.

Die Durchbiegung des Piezosensorelements 15 führt darin zu einer Ladungstrennung, die über Leitungen 16 an einer zugeordneten Sensorlogik 17 erfasst wird. Durch die Sensorlogik 17 werden die Sensorsignale in Sensorlogikwerte umgewandelt, durch die eine Aktion bzw. Aktionen der mit dem Bedienelement 13 verbundenen Gerätefunktion(en) ausgelöst werden. Die Sensorlogik 17 kann in das Bedienelement 13 integriert sein, wie in der Figur dargestellt, oder alternativ extern angeordnet sein.

Eine Berührungsdauer kann zumindest bei kurzer, kräftiger Betätigung des Bedienelementes 13 erfasst und zur Gerätesteuerung verwendet werden. Hierbei problematisch ist eine längere Betätigung und / oder ein nur sanftes Lösen der Berührung. Bei längerer Betätigung sinkt für das Piezo-Sensorelement 15 das Spannungsniveau ab, da die Ladungstrennung mit der Zeit aufgehoben wird. Bei sanftem Lösen der Betätigung, zum Beispiel bei langsamem seitlichen Gleiten des Finger, ist die Dehnung pro Zeit im Piezosensorelement 15 häufig zu lang, als dass ein ausreichendes Spannungssignal zuverlässig erfasst werden kann.

FIG 3 zeigt eine Bedienelementanordnung, bei der nun zusätzlich zu den Bedienelementen 13 aus FIG 2 einen Bedienflächenberührungssensor 18 in Form eines Impedanzsensors 18 vorhanden, dem über eine Leitung 19 eine Sensorlogik 20 zugeordnet ist. Der Impedanzsensor 18 erfasst dauerunabhängig eine Berührung des leitfähigen Teils der Hausgerätefläche 14. Die Impedanzmessung, die zudem ortsunabhängig ist, kann bei verschiedenen Frequenzen durchgeführt werden, z. B. bei ca. 15 - ca. 100 Hz oder bei ca. 450 KHz - ca. 500 KHz. Über Leitungen 21, 22 werden die von den Sensorlogiken 17,20 ausgegebenen Sensorlogikwerte an eine Auswerteschaltung 23 weitergeleitet. Dort kann die Betätigung eines Bedienelements bzw. des zugehörigen Piezosensorelements 15, die den Ort und den Anfangszeitpunkt der Berührung angibt, mit dem Wert des Impedanzsensors 18 gekoppelt werden, was eine Information über eine Berührungsdauer hinzufügt. Die Auswerteschaltung 23 kann beispielsweise ein Schwellwertschaltung, z. B. einen Schmitt-Trigger, umfassen.

Die gezeigten Ausführungsbeispiele sind nicht dazu gedacht, die Erfindung auf irgendeine Weise zu beschränken. So ist die Art des Bedienelementsensor nicht auf Piezosensoren beschränkt.

Zur Ermöglichung einer zuverlässigen Impedanzmessung können verschiedene leitfähige Bedienoberflächen verwendet werden, z. B. metall- oder polymerbeschichtete oder vollmetallische Flächen, und so weiter. Für die Impedanzmessung werden zwar 15-100 KHz oder 450-500 KHz bevorzugt, aber auch andere Bereiche sind dem Fachmann nach Durchlesen der vorliegenden Beschreibung, welche die Figuren und die Ansprüche umfasst, zugänglich, beispielsweise zwischen 100 KHz und 450 KHz.

Auch ist die Bedienflächenberührungsmessung nicht auf eine Impedanzmessung beschränkt, sondern kann beispielsweise auch optische Auskopplungen aus einem in eine Bedienfläche eingebrachten Lichtfeld verwenden, was bei lichtdurchlässigen Bedienflächen sinnvoll sein kann, die dann nicht mehr elektrisch leitfähig zu sein brauchen, z. B. zumindest bei transparenten Glaskeramiken.

Ein Bedienelement kann auch mehrere Bedienelementsensoren aufweisen, z. B. kann ein Gleitstreifen, wie ein Linear- und / oder Zirkulargleitstreifen, mehrere in Gleitrichtung nebeneinander angeordnete Bedienelementsensoren oder Bedienelementsensorbereiche aufweisen, wodurch eine Ortsauflösung auf dem Gleitstreifen erreicht wird, z. B. zur Richtungserkennung. Bei Gleiten über einen Gleitstreifen ohne Abheben des Fingers erfasst beispielsweise der Impedanzsensor eine dauernde Berührung der Bedienoberfläche, während die Bedienelementsensoren bzw. Bedienelementsensorbereiche des Gleitstreifens die Ortsveränderung erfassen. Bei jedem Übergang zu einem anderen Sensorbereich des Gleitstreifens zu einem anderen wird die Berührungserkennung durch den Bedienflächenberührungssensor dem aktuellen Bedienelementsensor bzw. Bedienelementsensorbereich neu zugewiesen, d. h. in anderen Worten, dass die durch den Bedienflächenberührungssensor erfasste Berührungsdauer beim Übergang von einem Bedienelementsensor zum nächsten bzw. beim Übergang von einem Bedienelementsensorbereich zum nächsten (ohne Abheben eines Fingers) logisch zurückgesetzt werden kann.

Durch die Erfindung können Gleitstreifen zudem nun zumindest in Teilabschnitten als Dauerstelltasten verwendet werden, z. B. um Kochstufen oder Zeitdauern (Kochzeiten, Weckerzeiten usw.) durch Dauerbetätigung zu inkrementieren oder zu dekrementieren, und zwar abhängig vom Berührungsort auf dem Stellstreifen, z. B. 'links der Mitte' = dekrementieren und 'rechts der Mitte' = inkrementieren.

## Patentansprüche

1. Bedienvorrichtung, insbesondere für Haushaltsgeräte, aufweisend zumindest ein berührungsempfindliches Bedienelement (6,8;13), das eine Bedienfläche (14) mit zumindest einem daran angebrachten Bedienelementsensor (15) aufweist, welcher eine Verformung der Bedienfläche (14) am Bedienelement (6,8;13) erfasst, wobei die Bedienvorrichtung weiterhin einen Bedienflächenberührungssensor (18) zur dauerunabhängigen Erfassung einer Berührung der Bedienfläche (15) aufweist, wobei der Bedienelementsensor (15) und der Bedienflächenberührungssensor (18) mit einer gemeinsamen Auswertelogik (23) verbunden sind, welche eine Betätigung des Bedienelementesensors (15) aus einem vom Bedienelementsensor (15) ausgegebenen Bedienelementsensorwert erkennt, **dadurch gekennzeichnet, dass** die Auswertelogik eine Dauer einer Betätigung des Bedienelementsensors (15) aus einem vom Bedienflächenberührungssensor (18) ausgegebenen Bedienflächenberührungswert erkennt.

2. Bedienvorrichtung nach Anspruch 1, **dadurch gekennzeichnet, dass** der Bedienflächenberührungssensor ein Impedanzsensor (18) ist.

3. Bedienvorrichtung nach Anspruch 2, **dadurch gekennzeichnet, dass** der Impedanzsensor (18) eine Impedanz einer elektrisch leitfähigen bedienerseitigen Oberfläche der Bedienfläche (14) erfasst.

4. Bedienvorrichtung nach einem der Ansprüche 2 oder 3, **dadurch gekennzeichnet, dass** der Impedanzsensor (18) mit einer Frequenz zwischen 15 und 100 KHz oder zwischen 450 und 500 KHz betrieben wird.

5. Bedienvorrichtung nach einem der vorhergehenden Ansprüche, **dadurch gekennzeichnet, dass** der Bedienelementsensor ein piezoelektrischer Sensor (15) ist.

6. Bedienvorrichtung nach einem der vorhergehenden Ansprüche, **dadurch gekennzeichnet, dass** das berührungsempfindliche Bedienelement (6,8;13) ein Gleitstreifen (6) ist.

7. Verfahren zum Bedienen einer Bedienvorrichtung, die zumindest ein berührungsempfindliches Bedienelement (6,8;13) aufweist, das wiederum eine Bedienfläche (14) mit zumindest einem daran angebrachten Bedienelementsensor (15) aufweist, welcher eine Verformung der Bedienfläche (14) am Bedienelement (6, 8; 13) erfasst, wobei die Bedienvorrichtung weiterhin einen Bedienflächenberührungssensor (18) aufweist, der eine Berührung der Bedienfläche (14) dauerunabhängig erfassen kann, und das Verfahren die folgenden Schritte umfasst:
- Erfassen einer Berührung der Bedienfläche (14) durch den Bedienelementsensor (15) und Ausgeben eines zugehörigen Sensorwerts an eine zugeordnete Auswertelogik (17);
- Erfassen einer Berührung der Bedienfläche (14) durch den Bedienflächenberührungssensor (18) und Ausgeben eines zugehörigen Sensorwerts an eine zugeordnete Auswertelogik (20);
- Erzeugen eines Stellsignals für die dem Bedienelementsensor (15) zugeordnete Gerätefunktion aus den Sensorwerten, wobei eine Stellsignalinformation über die Betätigung des Bedienelementsensors (15) aus dem zugehörigen Sensorwert des Bedienelementsensors (15) abgeleitet wird
wobei das Verfahren **dadurch gekennzeichnet ist, dass** eine Stellsignalinformation über die Betätigungsdauer des Bedienelementsensors (15) aus dem Sensorwert des Bedienflächenberührungssensors (18) abgeleitet wird.

8. Haushaltsgerät, insbesondere Kochgerät (2), mit einer Bedienvorrichtung nach einer der Ansprüche 1 bis 7.

## Claims

1. Control device, particularly for domestic appliances, comprising at least one touch-sensitive control element (6, 8; 13), which has a control surface (14) with at least one control element sensor (15), which is mounted thereat and which detects a deformation of the control surface (14) at the control element (6, 8; 13), wherein the control device further comprises a control surface touch sensor (18) for duration-independent detection of touching of the control surface (15), wherein the control element sensor (15) and the control surface touch sensor (18) are connected with a common logical evaluating system (23) which recognises actuation of the control element sensor (15) from a control element sensor value output by the control element sensor (15), **characterised in that** the logical evaluating system recognises a duration of actuation of the control element sensor (15) from a control surface contact value output by the control surface touch sensor (18).

2. Control device according to claim 1, **characterised in that** the control surface touch sensor is an impedance sensor (18).

3. Control device according to claim 2, **characterised in that** the impedance sensor (18) detects an impedance of an electrically conductive surface, which is at the user side, of the control surface (14).

4. Control device according to one of claims 2 and 3, **characterised in that** the impedance sensor (18) is operated at a frequency between 15 and 100 KHz or between 450 and 500 KHz.

5. Control device according to any one of the preceding claims, **characterised in that** the control element sensor is a piezoelectric sensor (15).

6. Control device according to any one of the preceding claims, **characterised in that** the touch-sensitive control element (6, 8; 13) is a slide strip (6).

7. Method of controlling a control device, which comprises at least one touch-sensitive control element (6, 8; 13), which in turn has a control surface (14) with at least one control element sensor (15) which is mounted thereat and detects a deformation of the control surface (14) at the control element (6, 8; 13), wherein the control device further comprises a control surface touch sensor (18) which can detect touching of the control surface (14) independently of duration, and the method comprises the following steps:
- detecting touching of the control surface (14) by the control element sensor (15) and issuing an associated sensor value to an associated logical evaluating system (17);
- detecting touching of the control surface (14) by the control surface touch sensor (18) and issuing an associated sensor value to an associated logical evaluating system (20); and
- generating a setting signal for the appliance function, which is associated with the control element sensor (15), from the sensor values, wherein an item of setting signal information is derived by way of the actuation of the control element sensor (15) from the associated sensor value of the control element sensor (15); and
wherein the method is **characterised in that** an item of setting signal information is derived by way of the actuating duration of the control element sensor (15) from the sensor value of the control surface touch sensor (18).

8. Domestic appliance, particularly cooking appliance (2), with a control device according to any one of claims 1 to 7.

## Revendications

1. Dispositif de commande, en particulier pour des appareils électroménagers, qui présente au moins un élément de commande sensible au contact (6, 8; 13) qui présente une surface de commande (14) avec au moins un capteur d'élément de commande (15) y apposé, lequel comprend une déformation de la surface de commande (14) sur l'élément de commande (6, 8; 13), dans lequel le dispositif de commande présente en outre un capteur de contact de surface de commande (18) pour la saisie indépendante de la durée d'un contact de la surface de commande (15), dans lequel le capteur d'élément de commande (15) et le capteur de contact de surface de commande (18) sont reliés par une logique d'évaluation commune (23), laquelle reconnaît un actionnement du capteur d'élément de commande (15) au départ d'une valeur de capteur d'élément de commande émise par le capteur d'élément de commande (15), **caractérisé en ce que** la logique d'évaluation reconnaît une durée d'un actionnement du capteur d'élément de commande (15) au départ d'une valeur de contact de surface de commande émise par le capteur de contact de surface de commande (18).

2. Dispositif de commande selon la revendication 1, **caractérisé en ce que** le capteur de contact de surface de commande est un capteur d'impédance (18).

3. Dispositif de commande selon la revendication 2, **caractérisé en ce que** le capteur d'impédance (18) saisit une impédance d'une surface supérieure de la surface de commande (14) située du côté de l'utilisateur et conductrice d'électricité.

4. Dispositif de commande selon l'une des revendications 2 ou 3, **caractérisé en ce que** le capteur d'impédance (18) est exploité au moyen d'une fréquence entre 15 et 100 KHz ou entre 450 et 500 KHz.

5. Dispositif de commande selon l'une des revendications précédentes, **caractérisé en ce que** le capteur d'élément de commande est un capteur piézoélectrique (15).

6. Dispositif de commande selon l'une des revendications précédentes, **caractérisé en ce que** l'élément de commande sensible au contact (6, 8; 13) est une bande à curseur (6).

7. Procédé de commande d'un dispositif de commande qui présente au moins un élément de commande sensible au contact (6, 8; 13) qui présente une nouvelle fois une surface de commande (14) avec au moins un capteur d'élément de commande (15) y apposé, lequel comprend une déformation de la surface de commande (14) sur l'élément de commande (6, 8 ; 13), dans lequel le dispositif de commande présente en outre un capteur de contact de surface de commande (18) capable de reconnaître un contact de la surface de commande (14) indépendamment de la durée, le procédé comprenant les étapes suivantes:
- la saisie d'un contact de la surface de commande (14) par le capteur d'élément de commande (15) et l'émission d'une valeur de capteur correspondante à une logique d'évaluation (17) affectée ;
- la saisie d'un contact de la surface de commande (14) par le capteur de contact de surface de commande (18) et l'émission d'une valeur de capteur correspondante à une logique d'évaluation affectée (20) ;
- la génération, au départ des valeurs de capteur, d'un signal de réglage pour la fonction d'appareil affectée au capteur d'élément de commande (15), dans laquelle une information de signal de réglage quant à l'actionnement du capteur d'élément de commande (15) est déduite de la valeur de capteur correspondante du capteur d'élément de commande (15) ; le procédé étant **caractérisé en ce qu'**une information de signal de réglage quant à la durée d'actionnement du capteur d'élément de commande (15) est déduite de la valeur de capteur du capteur de contact de surface de commande (18).

8. Appareil électroménager, en particulier appareil de cuisson (2) avec un dispositif de commande selon l'une des revendications 1 à 7.
